# EUROPEAN PATENT SPECIFICATION

(11) **EP 0 587 237 B1**
(45) Date of publication and mention of the grant of the patent: **29.01.1997**
(21) Application number: 93202552.1
(22) Date of filing: 01.09.1993
(51) Int. Cl.: G02F 1/1335, C23C 14/18

(54) **Display device**
Wiedergabeanordnung
Dispositif de réproduction d'image

(30) Priority: 08.09.1992 EP 92202711
(43) Date of publication of application: 16.03.1994
(73) Proprietor: Philips Electronics N.V., 5621 BA Eindhoven (NL)
(72) Inventor: Vink, Teunis Johannes, c/o INT. OCTROOIBUREAU B.V., NL-5656 AA Eindhoven (NL); Walrave, Willem, c/o INT. OCTROOIBUREAU B.V., NL-5656 AA Eindhoven (NL)
(74) Representative: Raap, Adriaan Yde

(56) References cited:
- EP-A- 0 499 642
- PATENT ABSTRACTS OF JAPAN vol. 16, no. 58 (P-1311)13 February 1992 & JP-A-03 256 025 (TOSHIBA) 14 November 1991
- PATENT ABSTRACTS OF JAPAN vol. 15, no. 364 (P-1252)13 September 1991 & JP-A-03 142 417 (SHARP) 18 June 1991
- PATENT ABSTRACTS OF JAPAN vol. 5, no. 168 (C-77)27 October 1981 & JP-A-56 096 075 (RICOH) 3 August 1981

## Description

The invention relates to a display device comprising an electro-optical display medium between two supporting plates, at least one supporting plate being provided with a picture electrode and a metal pattern which is light-reflecting at the side facing the supporting plate.

The invention also relates to the manufacture of a metal pattern on a supporting plate; such a supporting plate may comprise switching elements such as diodes, transistors *etc.* and also electrodes which may function as picture electrodes in a display device.

A display device of this type is suitable for displaying video information and alpha-numerical information by means of electro-optical display media such as liquid crystalline materials.

A display device of the type described in the opening paragraph is known from JP-A 3-256025. This document describes a liquid crystal display device in which a metal pattern constituting a black matrix is provided on one of the supporting plates. The metal pattern is formed from a layer of highly reflecting material such as aluminium. Incident light is reflected at the location of the black matrix so that it cannot be incident on the switching elements arranged opposite this black matrix, which elements are usually light- sensitive. The metal pattern is coated with a layer of chromium oxide to prevent unwanted reflections in the layer of liquid crystalline material so that a better contrast is obtained.

A drawback of such a structure of the black matrix pattern of two layers is that this pattern will be relatively thick (approximately 0.5 µm), which leads to poor step coverages of electrodes which may be provided at a later stage. The provision of colour filters, orienting layers or protective layers may also give rise to problems in the case of a large thickness.

Moreover, the layer of chromium oxide provided on the metal pattern has a reflective power of approximately 10% so that not all consequences of internal reflections are eliminated. Notably in the case of use in projection display devices such a quantity of light may be incident on the switching elements that, for example leakage currents are introduced. Also the contrast may be detrimentally influenced by internal reflections.

In addition, problems occur in the manufacture of such double layers, notably because chromium oxide is provided by means of reactive sputtering. Without a very accurate process control, areas with a colour different from black are produced in the layer of chromium oxide (discolouration).

It is, *inter alia*, an object of the invention to provide a display device of the type described in the opening paragraph in which the above-mentioned problems are considerably reduced or eliminated.

To this end a display device according to the invention is characterized in that the metal pattern has a porous sub-layer at least at the side remote from the supporting plate.

In the porous sub-layer incident light is absorbed in such a way that the reflective power of the metal pattern is decreased to a value of 5% or less (to approximately 2 to 3%). The reflections still occurring are substantially completely specular so that there is no scattering towards proximate switching elements. To this end the metal layer preferably has a porosity of at least 50%. In this way detrimental effects due to internal reflections are considerably reduced.

As will be further described, a porous sub-layer may be obtained by means of a sputtering process. After the sub-layer has been provided, the reflective power may even be further decreased by etching the sputtered material in a standard wet-chemical etchant suitable for the material used or by oxidizing it in, for example an oxygen plasma. In this connection, notably high-melting point metals such as, for example chromium, tungsten, molybdenum and tantalum are very suitable.

The metal pattern provided in this way may be very thin (0.2 to 0.3 µm) so that the above-mentioned step coverage problems are largely prevented. Since the electric conductance of a metal track with one or more of such sub-layers remains very satisfactory, conducting parts other than the black matrix can also be realised by means of such a metal pattern, such as connection conductors which usually partly cover the (light-sensitive) transistors or other switching elements so that the consequences of internal reflections are also inhibited at these areas.

A method of providing a metal pattern according to the invention is characterized in that a (high-melting point) metal is deposited by means of sputtering and the sputtering pressure is increased for providing the porous sub-layer, whereafter the porous sub-layer is etched (and/or oxidized).

Since not very critical parameters (such as sputtering pressure, etching period and/or oxidation time) are varied during this process, the method is very flexible. The provision of a layer of chromium oxide by means of sputtering (reactive sputtering in oxygen) requires a much more complex process control.

These and other aspects of the invention will be apparent from and elucidated with reference to an embodiment described hereinafter. In the drawing
Fig. 1 is a diagrammatic cross-section of a part of a display device according to the invention and
Fig. 2 is a diagrammatic cross-section of a possible implementation of a metal pattern.

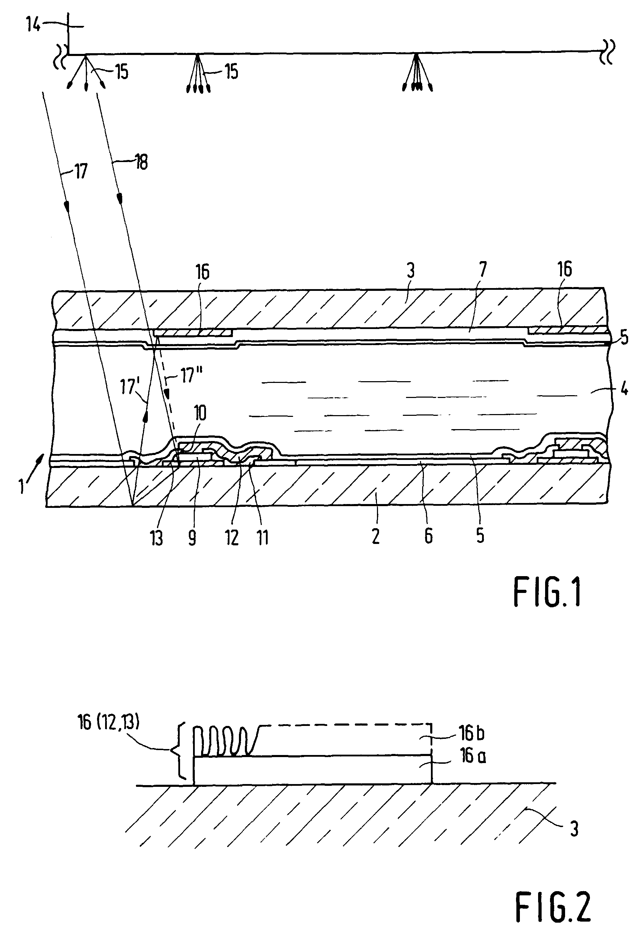

Fig. 1 is a diagrammatic cross-section of a part of a display device according to the invention. This device is a liquid crystal display device 1 having two transparent supporting plates 2 and 3 of glass or quartz between which, for example a twisted nematic liquid crystalline material 4 is present. A plurality of picture electrodes 6 of indium-tin oxide or another electrically conducting transparent material is arranged in rows and columns on the supporting plate 2. A transparent counterelectrode 7 of, for example indium-tin oxide defining the pixels of the display device together with facing picture electrodes is present on the other supporting plate 3. The picture electrodes 6 of the pixels are connecte*d via* switches 9, in this embodiment thin-film transistors, to column electrodes (not shown). For this purpose, the thin-film transistors are contacted *via* contact apertures 10 in an insulating layer 11 by means of contact conductors 12 which also contact the picture electrodes 6. The thin-film transistors are contacted at the lower side by electrodes 13, for example gate electrodes which may be integrated to row electrodes. The inner surfaces of the supporting plates (including picture electrodes, switching elements *etc.*) are provided with orienting layers 5 in generally known manner. The display device may be realised as a transmissive or reflective device and may be provided with, for example polarizers.

A colour filter may also be present on the supporting plate 3. The relevant Figure shows a monochrome display device for projection purposes. In such a device use is made of a light source 14 which emits a beam of light which is as parallel as possible perpendicularly to the plane of the supporting plates (possibly *via* a system of lenses). The light is then blocked between the pixels by the black matrix 16 provided at the inner side of supporting plate 3, which matrix is reflecting at the side of the light source 14 in the relevant embodiment. No light is transmitted between the pixels and consequently possible light-sensitive elements located on the supporting plate 2 opposite the black matrix are protected against incident light, while less well- defined states between the pixels are not visible, which has a contrast-raising effect.

However, in practice the light is emitted as a slightly diverging beam (with an apex angle of approximately 15 degrees). This is diagrammatically shown in Fig. 1 by means of the arrows 15. This means that light which is passed at the location of a light-transmissive pixel and which follows, for example the light path denoted by the arrow 17 is partially reflected at the glass-air interface. This partially reflected light (arrow 17') may subsequently be incident on the side of the black matrix remote from the supporting plate 3 and without special measures it may be incident on the light-sensitive switch 9 (arrow 17'') *via* reflection on this black matrix. In extreme cases light emitted by the light source 14 may even be directly incident on this switching element (arrow 18). In this respect it is to be noted that the effect of reflections on the intermediate layers 5, 6, 7 and 11 has not been considered for the sake of clarity.

According to the invention, light reflections are prevented by the black matrix 16 at the side remote from the supporting plate 3 by providing the metal layer from which the black matrix is formed with a porous sub-layer at this side. This is further illustrated in Fig. 2 showing a cross-section of a part of such a black matrix 16 which comprises a first sub-layer 16^{a} of, for example chromium and a second porous sub-layer 16^{b}, also of chromium. The porous sub-layer has a reflective power of 5% or less, so that reflection towards the light-sensitive switching elements hardly occurs. Possible reflections which are directly incident can be absorbed by realising the metallization pattern 12 also as such an assembly of sub-layers. The metallization 13 for the gate electrodes may also be formed as such a double layer and constitute a light shield. Even if the switching elements 9 are not contacted at their lower side, it may be advantageous to provide a light shield on the supporting plate 2. Also in passive display devices (without switching elements) a black matrix as described above may contribute to an enhancement of the contrast.

As described, the black matrix comprises a first sub-layer 16^{a} of chromium provided with a second porous sub-layer 16^{b}, also of chromium. The first sub-layer has a thickness of 100 nanometer, while the thickness of the second sub-layer is 150 nanometer. At such thicknesses no or hardly any step coverage problems occur. Said reflection coefficient of 5% or less is obtained at a porosity of the second sub-layer of 50% or more. Instead of chromium, other (high- melting point) metals may alternatively be chosen, such as tungsten, molybdenum or tantalum.

Such a metal pattern which reflects light incident at one side and which substantially completely absorbs light incident at the other side may be manufactured as follows.

Chromium is sputtered in an argon atmosphere on a glass supporting plate 3 (which may already be provided with picture electrodes and/or switching elements) at such a sputtering gas pressure that the mechanical stress in the layer is slightly compressive. The columns from which the resultant sub-layer 16^{a} is built up are situated close together. Subsequently, the sputtering gas pressure is considerably increased (by a factor of approximately 10). The composite columns of the sub-layer formed thereby are now spaced apart (Fig. 2) so that the sub-layer 16^{b} has a high porosity. Subsequently, the metal layer 16 is etched in the desired pattern.

The porosity of the sub-layer 16^{b} can be increased by etching in a standard wet-chemical etching bath. The light-absorbing power can be further increased by oxidizing the porous sub-layer in, for example an oxygen plasma; etching may then be dispensed with.

The invention is of course not limited to the embodiment described, but several variations are possible. For example, the black matrix 16 in Fig. 1 may alternatively be provided on the electrode 7. The metal layer 16 (12, 13) may comprise an extra sub-layer having a different porosity or a gradually increasing porosity.

## Claims

1. A display device comprising an electro-optical display medium between two supporting plates, at least one supporting plate being provided with a picture electrode and a metal pattern which is light-reflecting at the side facing the supporting plate, characterized in that the metal pattern has a porous sub-layer at least at the side remote from the supporting plate.

2. A display device as claimed in Claim 1, characterized in that the porous sub-layer comprises oxidized metal.

3. A display device as claimed in Claim 1 or 2, characterized in that the reflection coefficient of the metal layer for incident light is at most 5% at the side remote from the supporting plate.

4. A display device as claimed in Claim 1 or 2, characterized in that the porosity of the porous sub-layer is at least 50%.

5. A display device as claimed in any one of the preceding Claims, characterized in that the metal pattern comprises one of the metals chromium, tungsten, molybdenum or tantalum.

6. A display device as claimed in any one of the preceding Claims, characterized in that the metal pattern constitutes a black matrix.

7. A display device as claimed in Claim 6, characterized in that the black matrix, viewed perpendicularly to the supporting plates, is present at the location of a switching element.

8. A display device as claimed in any one of Claims 1 to 5, characterized in that the metal pattern comprises connection metallizations of switching elements or picture elements.

9. A method of providing a supporting plate with a metal pattern having a porous upper layer which is light-reflective at the side facing the supporting plate and light-absorbing at the other side, characterized in that the metal is deposited by means of sputtering and the sputtering pressure is increased for providing the porous upper layer, which porous upper layer is etched after sputtering.

10. A method of providing a supporting plate with a metal pattern having a porous upper layer which is light-reflecting at the side facing the supporting plate and light-absorbing at the other side, characterized in that the metal is deposited by means of sputtering and the sputtering pressure is increased for providing the porous upper layer, which porous upper layer is oxidized after sputtering.

## Patentansprüche

1. Wiedergabeanordnung mit einem elektrooptischen Wiedergabeschirm zwischen zwei Trägerplatten, von denen wenigstens eine Platte mit einer Bildelektrode und einem Metallmuster versehen ist, das auf der der Trägerplatte zugewandten Seite lichtreflektierend ist, dadurch gekennzeichnet, daß das Metallmuster wenigstens an der von der Trägerplatte abgewandten Seite eine poröse Teilschicht aufweist.

2. Wiedergabeanordnung nach Anspruch 1, dadurch gekennzeichnet, daß die poröse Teilschicht oxidiertes Metall aufweist.

3. Wiedergabeanordnung nach Anspruch 1 oder 2, dadurch gekennzeichnet, daß der Reflexionskoeffizient der Metallschicht für eintreffendes Licht höchstens 5% ist an der von der Trägerplatte abgewandten Seite.

4. Wiedergabeanordnung nach Anspruch 1 oder 2, dadurch gekennzeichnet, daß die Porösität der porösen Teilschicht wenigstens 50% ist.

5. Wiedergabeanordnung nach einem der vorstehenden Ansprüche, dadurch gekennzeichnet, daß das Metallmuster eines der Metalle Chrom, Wolfram, Molybdän oder Tantal aufweist.

6. Wiedergabeanordnung nach einem der vorstehenden Ansprüche, dadurch gekennzeichnet, daß das Metallmuster eine schwarze Matrix bildet.

7. Wiedergabeanordnung nach Anspruch 6, dadurch gekennzeichnet, daß die schwarze Matrix, senkrecht zu den Trägerplatten gesehen, an der Stelle eines Schaltelementes vorhanden ist.

8. Wiedergabeanordnung nach einem der Ansprüche 1 bis 5, dadurch gekennzeichnet, daß das Metallmuster Verbindungsmetallisierungen von Schaltelementen oder Bildelementen aufweist.

9. Verfahren zum Anbringen eines Metallmusters auf einer Trägerplatte, wobei dieses Muster eine poröse Oberschicht aufweist, die auf der Seite, die der Trägerplatte zugewandt ist, lichtreflektierend ist und auf der anderen Seite Licht absorbiert, dadurch gekennzeichnet, daß das Metall im Zerstäubungsverfahren angebracht wird und der Zerstäubungsdruck zum Anbringen der porösen Schicht gesteigert wird, wobei diese poröse obere Schicht nach dem Zerstäubungsvorgang geätzt wird.

10. Verfahren zum Anbringen eines Metallmusters auf einer Trägerplatte, wobei dieses Metallmuster eine poröse obere Schicht aufweist, die auf der Seite, die der trägerplatte zugewandt ist, lichtreflektierend und auf der anderen Seite lichtschluckend ist, dadurch gekennzeichnet, daß das Metall im Zerstäubungsverfahren angebracht wird und der Zerstäubungsdruck zum Anbringen der porösen oberen Schicht gesteigert wird, wobei diese poröse obere Schicht nach dem Zerstäubungsvorgang oxidiert wird.

## Revendications

1. Dispositif d'affichage comprenant un milieu d'affichage électro-optique entre deux plaques de support, au moins une plaque de support étant pourvue d'une électrode d'image et d'un motif métallique qui réfléchit la lumière du côté tourné vers la plaque de support, caractérisé en ce que le motif métallique présente une sous-couche poreuse au moins du côté éloigné de la plaque de support.

2. Dispositif d'affichage selon la revendication 1, caractérisé en ce que la sous-couche poreuse comprend un métal oxydé.

3. Dispositif d'affichage selon la revendication 1 ou 2, caractérisé en ce que le coefficient de réflexion de la couche métallique pour la lumière incidente est au maximum de 5% du côté éloigné de la plaque de support.

4. Dispositif d'affichage selon la revendication 1 ou 2, caractérisé en ce que la porosité de la sous-couche poreuse est d'au moins 50%.

5. Dispositif d'affichage selon l'une quelconque des revendications précédentes, caractérisé en ce que le motif métallique comprend un des métaux comprenant le chrome, le tungstène, le molybdène ou le tantale.

6. Dispositif d'affichage selon l'une quelconque des revendications précédentes, caractérisé en ce que le motif métallique constitue une matrice noire.

7. Dispositif d'affichage selon la revendication 6, caractérisé en ce que la matrice noire, observée perpendiculairement aux plaques de support, est présente à l'emplacement d'un élément de commutation.

8. Dispositif d'affichage selon l'une quelconque des revendications 1 à 5, caractérisé en ce que le motif métallique comprend des métallisations de connexion d'éléments de commutation ou d'éléments d'image.

9. Procédé permettant de munir une plaque de support d'un motif métallique ayant une couche poreuse supérieure qui réfléchit la lumière du côté tourné vers la plaque de support et absorbe la lumière de l'autre face, caractérisé en ce que le métal est déposé par pulvérisation cathodique et en ce que la pression de pulvérisation cathodique est augmentée pour former la couche poreuse supérieure, ladite couche poreuse supérieure étant soumise à attaque chimique après la pulvérisation cathodique.

10. Procédé permettant de munir une plaque de support d'un motif métallique ayant une couche poreuse supérieure qui réfléchit la lumière du côté tourné vers la plaque de support et absorbe la lumière de l'autre côté, caractérisé en ce que le métal est déposé par pulvérisation cathodique et en ce que la pression de pulvérisation cathodique est augmentée pour former la couche poreuse supérieure, ladite couche poreuse supérieure étant oxydée après la pulvérisation cathodique.
